(19) Europäisches Patentamt
European Patent Office
Office européen des brevets

(11) **EP 2 509 804 B1**

(12) **FASCICULE DE BREVET EUROPEEN**

(45) Date de publication et mention
de la délivrance du brevet:
**17.09.2014 Bulletin 2014/38**

(21) Numéro de dépôt: **10787438.0**

(22) Date de dépôt: **03.12.2010**

(51) Int Cl.:
*B60C 11/04* (2006.01)    *B60C 11/00* (2006.01)
*B60C 11/03* (2006.01)    *B60C 99/00* (2006.01)
*G06F 17/50* (2006.01)

(86) Numéro de dépôt international:
**PCT/EP2010/068888**

(87) Numéro de publication internationale:
**WO 2011/069927 (16.06.2011 Gazette 2011/24)**

(54) **METHODE DE DIMENSIONNEMENT D'UN PNEU ET PNEU**

VERFAHREN FÜR DEN ENTWURF EINES REIFENS UND REIFEN

METHOD OF DESIGNING A TYRE, AND TYRE

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **08.12.2009 FR 0958728**

(43) Date de publication de la demande:
**17.10.2012 Bulletin 2012/42**

(73) Titulaires:
• **Compagnie Générale des Etablissements
Michelin
63000 Clermont-Ferrand (FR)**
• **MICHELIN Recherche et Technique S.A.
1763 Granges-Paccot (CH)**

(72) Inventeur: **LHOSPITALIER, Sylvie
F-63720 Ennezat (FR)**

(74) Mandataire: **Diernaz, Christian
M. F. P. Michelin,
23, place des Carmes Dechaux,
DGD/PI-F35-Ladoux
63040 Clermont-Ferrand Cedex 09 (FR)**

(56) Documents cités:
**EP-A1- 1 440 822**     **WO-A1-2009/048078**
**WO-A1-2009/128098**     **US-A1- 2007 151 643**

**Description**

L'invention concerne les pneus pour véhicules poids lourd et plus particulièrement les pneus destinés à équiper les essieux directeurs de ces véhicules.

Un pneu pour véhicule portant de lourdes charges comprend une bande de roulement destinée à assurer le contact en roulage du pneu avec la chaussée et à transmettre des efforts dans la direction de roulage (efforts moteur ou freineur) et dans une direction transverse à la direction de roulage (efforts en virage). Cette bande de roulement est pourvue d'une pluralité de creux se présentant sous la forme de rainures et /ou d'incisions pour améliorer les conditions de roulage lorsque la chaussée est revêtue d'eau ou de neige. Ces rainures délimitent des éléments de relief (nervures ou blocs) répartis sur la bande de roulement ; on distingue des parties de bord délimitant axialement la bande de roulement et des parties intermédiaires situées axialement entre ces parties de bord.

Par ailleurs, un pneu comprend, outre une bande de roulement, des bourrelets destinés à être en contact avec une jante de montage, un flanc reliant chaque bourrelet à une région de sommet, cette dernière étant coiffée par la bande de roulement. L'ensemble du pneu est renforcé par une armature de carcasse ancrée à ses deux extrémités dans les bourrelets et s'étendant dans les flancs et dans la région de sommet. Radialement entre l'armature de carcasse et la bande de roulement on trouve une armature de sommet. L'armature de carcasse est dite radiale dès lors que ses renforts sont orientés dans une direction faisant un angle supérieur ou égal à 80 degrés avec une direction tangente à la direction circonférentielle.

Le document US-A-2007/0151643 décrit un pneu pour poids lourd, ce pneu étant configuré pour avoir une moindre usure irrégulière.

<u>Définitions</u>

Par direction radiale; on entend dans le présent document une direction qui est perpendiculaire à l'axe de rotation du pneu (cette direction correspond à la direction de l'épaisseur de la bande de roulement).

Par direction axiale, on entend une direction parallèle à l'axe de rotation du pneu.

Par direction circonférentielle, on entend une direction qui est perpendiculaire à la fois à la direction axiale et à une direction radiale.

Par axialement vers l'extérieur, on entend une direction qui est orientée vers l'extérieur de la cavité interne du pneu.

Plan équatorial : plan perpendiculaire à l'axe de rotation et passant par les points du pneu axialement les plus à l'extérieur, ce plan équatorial divisant virtuellement le pneu en deux moitiés sensiblement égales.

Selon la position de montage d'un pneu sur un véhicule poids lourd les conditions d'efforts supportées par le pneu sont modifiées, ce qui explique que l'on cherche à adapter à chaque essieu un pneu spécifique.

Lorsqu'on examine des pneus montés sur essieu directeur, on constate qu'il peut survenir une usure irrégulière (dite "usure rail") qui se manifeste axialement à l'extérieur des parties de bord. Par usure irrégulière, on entend ici une usure qui se trouve plus prononcée sur une région localisée d'un élément de relief de la bande. Dans le cas de l'usure rail, c'est la région axialement la plus à l'extérieur des éléments de relief de la partie de bord de la bande qui s'use plus vite que le reste de la face de contact de ces éléments. Cette usure irrégulière peut générer des phénomènes de vibration dans le véhicule et conduire alors l'usager à démonter prématurément ses pneus afin de renouveler la bande de roulement ou changer de pneu.

Ce problème a déjà fait l'objet de proposition de solution et notamment il a été proposé d'adjoindre axialement à l'extérieur des parties de bord une petite nervure (dite "nervure sacrifiée") ayant des dimensions appropriées pour en quelque sorte prendre sur elle toute l'usure irrégulière. Cette solution en éloignant l'usure irrégulière permet d'assurer une usure régulière et donc homogène sur toute la partie de bord adjacente à la nervure sacrifiée.

Cette solution trouve cependant ses limites pour des pneus qui peuvent en utilisation être soumis à des régimes de sollicitations sévères, occasionnant alors des arrachements de matière sur la nervure sacrifiée. Ceci a pour effet de rendre la nervure sacrifiée inefficace pour traiter l'usure irrégulière, et d'autre part de diminuer l'endurance globale du pneu lorsque certains de ces arrachements arrivent à se propager dans un flanc du pneu.

L'objectif de l'invention est de résoudre à la fois ce problème d'usure irrégulière sur les pneus montés sur essieu directeur tout en évitant la sensibilité à l'arrachement dans des conditions d'usage particulièrement sévères.

L'objet de l'invention concerne une bande de roulement pour pneu de véhicule poids lourd satisfaisant à l'objectif précisé plus haut, ainsi qu'une méthode de dimensionnement d'un tel pneu.

Il est ici proposée une méthode de dimensionnement d'un pneu destiné à être monté sur l'essieu directeur d'un véhicule poids lourd, ce pneu comprenant des bourrelets destinés à être en contact avec une jante de montage du pneu, ces bourrelets étant prolongés par des flancs, ces derniers se raccordant à une région de sommet elle même surmontée par une bande de roulement destinée à venir en contact avec la chaussée en roulage, le pneu ayant une hauteur de flanc **F** nominale, l'armature de sommet comprenant au moins deux nappes de renfort superposées, la bande de roulement ayant à l'état neuf une largeur **Lo** de contact au sol maxi et étant pourvue d'au moins quatre rainures circonférentielles ayant chacune une largeur et s'étendant chacune entre la surface de roulement de la bande de roulement et un fond de rainure, ces rainures délimitant trois nervures intermédiaires et deux nervures de bord limitant axialement ladite bande, chaque nervure de bord ayant deux parois latérales, l'une de ces parois latérales, dite paroi latérale interne, ayant une hauteur **PREp** mesurée par rapport au fond de la rainure délimitant ladite nervure de bord, cette paroi latérale interne ayant, vue en coupe dans un plan contenant l'axe de rotation, une inclinaison **DEp,** chaque nervure de bord ayant une largeur **LEp** plus grande que la largeur de chacune des nervures intermédiaires. Cette méthode de dimensionnement consiste à déterminer de façon itérative des valeurs des dimensions **LEp, PREp,** et **DEp** qui satisfont la relation suivante

$$P(LEp, \ DEp, \ PREp) \ < \ 1.105769231 \ x \ F,$$

(x représentant l'opération de multiplication)
où la valeur de **P(LEp, DEp, PREp)** est obtenue en effectuant le calcul suivant :

$$P(LEp, \ DEp, \ PREp) = -303.528 - 2.00675 \ x \ LEp + 10.2755 \ x \ DEp + 81.0414 \ x$$
$$PREp - 0.052551 \ x \ LEp^2 - 0.0825991 \ x \ LEp \ x \ DEp + 0.225564 \ x \ LEp \ x \ PREp -$$
$$0.111262 \ x \ DEp^2 - 0.209215 \ x \ DEp \ x \ PREp - 2.5831 \ x \ PREp^2,$$

les longueurs **LEp** et **PREp** étant exprimées en millimètres (mm), et l'angle **DEp** en degrés (°).

Grâce à la méthode de dimensionnement selon l'invention, il est possible d'obtenir un pneu dont la bande de roulement offre des performances pérennes c'est-à-dire sensiblement conservées quel que soit le niveau d'usure de cette bande. La présente invention permet en outre de maîtriser l'échauffement thermique dans les régions de bord de la bande.

Dans l'expression utilisée pour mettre en oeuvre la méthode selon l'invention, la hauteur **F** du flanc d'un pneumatique est calculée en utilisant la formule suivante :

**F = ARRONDI** [(largeur axiale maximale du pneu x H/S)/100 - **Hc],** dans laquelle H/S représente le ratio de forme du pneu, et **Hc** est égale à la hauteur du crochet de jante laquelle hauteur est pour un pneu de type *"drop center"* égale à 12.7 mm.

Par **ARRONDI** on entend une fonction qui a pour résultat la valeur entière inférieure d'un nombre dont la partie fractionnaire/décimale est au plus égale à 0.5 et qui donne la valeur entière supérieure d'un nombre si sa partie fractionnaire/décimale est plus grande que 0.5. Par exemple : **ARRONDI(2.4)** vaut 2 et **ARRONDI(2.6)** vaut 3.

Avantageusement, la méthode de dimensionnement est telle que pour chaque nervure intermédiaire, la différence entre les profondeurs de deux rainures délimitant une même nervure est faible, c'est-à-dire que cette différence est au plus égale à 10% de la plus grande des profondeurs de ces rainures.

De manière avantageuse, la méthode de dimensionnement est appliquée au cas où la nervure de bord et la nervure directement adjacente sont de hauteurs différentes, et telles que la différence entre ces hauteurs est au plus égale à 15% de la plus petite de ces hauteurs.

De manière avantageuse, la méthode de dimensionnement est appliquée au cas où l'angle **DEp** de la paroi latérale interne de chaque nervure bord avec une direction radiale est choisi pour être au plus égal à 26 degrés, et l'angle de la paroi latérale en vis-à-vis dans la même rainure est choisi pour être au plus égal à 20 degrés. Encore plus avantageusement dans ce dernier cas, la méthode de dimensionnement est appliquée au cas où la largeur de chaque nervure bord **Lep** est choisie de manière à être au moins 1.85 fois supérieure à la largeur de toute autre nervure intermédiaire. Encore plus préférentiellement l'angle **DEp** de la paroi latérale interne de chaque nervure bord avec une direction radiale est choisi dans un intervalle allant de 10 degrés à 26 degrés, l'angle de la paroi latérale en vis-à-vis dans la même rainure étant choisi pour être au plus égal à 20 degrés.

Pour la mise en oeuvre de la méthode selon l'invention, il est préférable de choisir un premier triplet de valeurs pour **LEp, PREp,** et **DEp** puis, si la relation **P(LEp, DEp, PREp)** < 1.105769231 x F, n'est pas satisfaite, à augmenter dans un premier temps la valeur de la largeur **LEp** de la nervure épaule, ensuite à diminuer la hauteur **PREp** de la paroi latérale interne, et finalement à augmenter la valeur de l'angle **DEp** de la paroi latérale interne.

L'invention concerne également un pneu obtenu grâce à la méthode selon l'invention.

Il est ainsi proposé un pneu destiné à être monté sur l'essieu directeur d'un véhicule poids lourd, ce pneu comprenant des bourrelets destinés à être en contact avec une jante de montage du pneu, ces bourrelets étant prolongés par des flancs, ces derniers se raccordant à une région de sommet elle même surmontée par une bande de roulement destinée à venir en contact avec la chaussée en roulage, le pneu ayant une hauteur de flanc **F** nominale, une armature de sommet comprenant au moins deux nappes de renfort superposées, la bande de roulement ayant, à l'état neuf, une largeur maximale Lo de contact au sol en conditions usuelles d'usage et, cette bande étant pourvue d'au moins quatre rainures circonférentielles ayant chacune une largeur et s'étendant chacune entre la surface de roulement de la bande de roulement et un fond de rainure, ces rainures délimitant trois nervures intermédiaires et deux nervures de bord limitant axialement ladite bande, chaque nervure de bord ayant deux parois latérales, l'une de ces parois latérales, dite paroi latérale interne, ayant une hauteur **PREp** mesurée par rapport au fond de la rainure délimitant ladite nervure de bord, cette paroi latérale interne ayant, vue en coupe dans un plan contenant l'axe de rotation, une inclinaison **DEp**, cet angle étant tel que les points de cette paroi latérale radialement les plus à l'intérieur sont plus proches du plan équatorial du pneu que les points de la même paroi latérale radialement les plus à l'extérieur chaque nervure de bord ayant une largeur **LEp** plus grande que la largeur de chacune des nervures intermédiaires, un plan équatorial perpendiculaire à l'axe de rotation du pneu et passant par les points du pneu radialement les plus éloignés de l'axe de rotation, ce pneu étant caractérisé en ce que la largeur de la nervure bord **LEp,** l'angle de la paroi latérale d'une nervure bord **DEp,** et la hauteur **PREp** de la paroi latérale interne de la nervure de bord satisfont la relation suivante :

$$P(LEp,\ DEp,\ PREp) < 1.105769231 \times F$$

où la valeur de **P(LEp, DEp, PREp)** est obtenue en effectuant le calcul suivant :

$$P(LEp,\ DEp,\ PREp) = -303.528 - 2.00675 \times LEp + 10.2755 \times DEp + 81.0414 \times PREp - 0.052551 \times LEp^2 - 0.0825991 \times LEp \times DEp + 0.225564 \times LEp \times PREp - 0.111262 \times DEp^2 - 0.209215 \times DEp \times PREp - 2.5831 \times PREp^2.$$

Avantageusement et en combinaison avec l'usage de la méthode de dimensionnement selon l'invention, le pneu selon l'invention comprenant une armature de sommet sous la bande de roulement, cette armature de sommet comprenant plusieurs nappes de renforts superposées est telle que l'extrémité de la nappe sommet la plus large axialement est située, par rapport au plan équatorial du pneu, axialement à une distance supérieure à la distance axiale de la rainure axialement le plus à l'extérieure. Ainsi cette nappe de sommet la plus large est présente radialement sous la nervure épaule sur une distance au moins égale à 75 % de la largeur totale **LEp** de cette nervure épaule.

De façon avantageuse, le pneu selon l'invention est tel que la largeur de chaque rainure, mesurée sur la surface de roulement à l'état neuf, est au moins égale à 3% de la largeur totale Lo de la bande de roulement.

Il est préférable que l'angle d'inclinaison **DEp** de la paroi latérale interne de la nervure bord et l'angle d'inclinaison de la paroi en vis-à-vis de cette paroi latérale interne soient tels que la somme de ces deux angles est supérieure ou égale à 26 degrés.

Encore plus préférentiellement, l'angle d'inclinaison **DEp** de la paroi latérale interne de la nervure bord varie continûment à partir d'une valeur minimale satisfaisant la relation **P(LEp, DEp, PREp)** < 1.105769231x**F,** cette valeur restant toujours supérieure ou égale à 10 degrés.

Grâce à cette invention il est ainsi possible d'augmenter de 20% le kilométrage avant l'apparition de l'usure en "rail" par rapport à une conception usuelle (c'est-à-dire sans la présence d'une nervure sacrifiée) ; il est en outre possible de repousser d'environ 40% le kilométrage avant que n'apparaissent des problèmes (comme des vibrations) liés à l'usure irrégulière aux bords de la bande.

Dans certaines applications de l'invention à des pneus roulant sur des chaussées sur lesquelles peuvent être présents des cailloux, il peut être nécessaire de mettre en place des protubérances dans les rainures délimitées par les nervures de bord de manière à protéger le fond desdites rainures. Dans pareil cas, l'angle d'inclinaison DEp de la paroi latérale interne de la nervure bord est préférentiellement limité à au plus 6 degrés, ceci afin que ces protubérances ne soient pas fragilisées. Les protubérances dont il est question peuvent être continues circonférentiellement ou bien discontinues. Elles ont de préférence une hauteur au moins égale à 50% de la hauteur **PREp** de la paroi latérale interne de la nervure de bord et une largeur au moins égale à la moitié de la largeur de la rainure dans laquelle elles sont formées.

D'autres caractéristiques et avantages de l'invention ressortent de la description faite ci-après en référence aux figures annexées qui montrent, à titre d'exemple non limitatif, une forme de réalisation de l'objet de l'invention :

La figure 1 montre une vue en plan d'une partie de la bande de roulement ;

La figure 2 montre une vue en coupe d'un pneu construit en mettant en oeuvre la méthode de l'invention ;

La figure 3 montre une variante d'un pneu construit selon l'invention et pour lequel l'armature de sommet se prolonge radialement sous les nervures bord ;

La figure 4 montre en coupe une variante d'un pneu selon l'invention, ce pneu comprenant des protubérances de protection de fond de rainures.

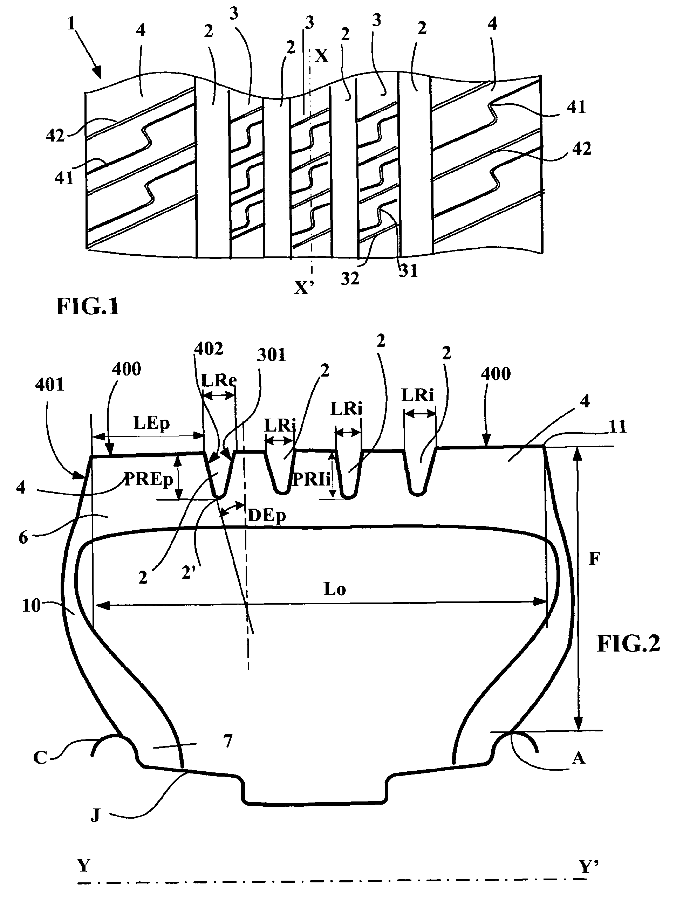

La figure 1 montre une vue en plan d'une partie de la bande de roulement 1 construite selon l'invention pour un pneu destiné à équiper l'essieu directeur d'un véhicule poids lourd. Cette bande comprend quatre rainures 2 d'orientation circonférentielle, ces rainures délimitant trois nervures intermédiaires 3 et deux nervures bord 4 aux extrémités axiales la bande. Ces nervures 3, 4 sont en outre pourvues avec des rainures ou incisions 31, 32, 41, 42 de largeur faible comparativement aux largeurs des rainures circonférentielles 2. Ces rainures ou incisions additionnelles sont, dans le cas présenté, orientées obliquement par rapport à la direction circonférentielle représentée par la direction XX' sur la figure 1.

La figure 2 montre partiellement le pneu de la figure 1 vu en coupe dans un plan contenant l'axe de rotation YY' du pneu. Ce pneu comprenant des bourrelets 7 en appui sur une jante de montage J, celle-ci comprenant des parties axialement à l'extérieur formant crochet de jante C. Sur cette coupe, on voit que ce pneu comprend des flancs 10 prolongeant les bourrelets 7, et se prolongeant radialement au delà des crochets de jante C, ces flancs étant reliés entre eux par une partie de sommet 6. Cette partie de sommet du pneu est pourvue radialement à l'extérieur avec la bande de roulement 1 dont le dessin de sculpture a été montré à la figure 1. Ce pneu a une hauteur de flanc F nominale égale à la distance mesurée dans la direction radiale séparant le bord axialement à l'extérieur 11 de la bande de roulement et le point radialement le plus à l'extérieur A de la jante de montage J dans le plan de coupe de la figure 2.

Sur cette figure 2, on voit que chaque nervure de bord 4 comprend une surface de contact 400 destinée à venir en contact avec la chaussée pendant le roulage et deux parois latérales 401, 402 coupant la surface de contact selon des arêtes, l'une de ces parois latérales, dite paroi latérale interne 402 délimitant, avec une paroi latérale 301 en vis-à-vis d'une nervure intermédiaire 3 voisine, une rainure 2 de largeur **LRE.** Cette rainure 2 à une profondeur **PREp** mesurée entre le fond 2' de la rainure et la surface de contact 400 de la nervure bord 4. Cette mesure **PREp** correspond à la hauteur de la nervure bord 4. Dans le cas présent, les nervures de bord et intermédiaires sont toutes sensiblement au même niveau, c'est-à-dire qu'aucune des surfaces de contact desdites nervures ne se trouve en décalage dans la direction radiale par rapport aux surfaces de contact d'au moins une autre nervure. Si cela était le cas, il faudrait considérer les hauteurs **PREp, PRi** de chaque paroi latérale de chaque nervure de bord et intermédiaire respectivement. Chaque nervure de bord a une largeur **LEp** et les nervures intermédiaires ont une largeur Li sensiblement identique et inférieure à la largeur **LEp.**

L'angle moyen d'inclinaison de la paroi latérale de la nervure de bord dans le plan de coupe de la figure 2 est noté **Dep.**

La méthode selon l'invention a été appliquée pour déterminer les paramètres dimensionnels de ce pneu de dimension 315/80 R22.5.

Pour ce pneu, la largeur axiale maximale Lo de la bande de roulement est égale à 315 mm, et le ratio de forme H/S est égal à 0.80. Sachant que la hauteur du crochet de la jante de montage de ce pneu est normalisée et égale à 12.5 mm, on obtient une valeur du paramètre **F** :

$$F = ARRONDI[\frac{315x80}{100} - 12.7] = ARRONDI[239.3] = 239mm$$

Pour le pneu selon l'invention, les rainures 2 ont une largeur égale à 14 mm, les nervures intermédiaires 3 ont des largeurs égales à 30 mm et les rainures, à l'exception des rainures délimitant les nervures de bord 4, ont des profondeurs égales à 16.2 mm. L'angle des parois latérales 301 des nervures intermédiaires est égal à 13°.

Sur un pneu de référence de l'art antérieur de même dimension 315/80R22.5 XZE2+, on a les dimensions suivantes : **LEp** = 47 mm, **DEp** = 15.7° et **PREp** = 16.2 mm.

Si on calcule **P(LEp, DEp, PREp)** pour ce pneu de l'art antérieur, on obtient **P** = 312.514697. Ce résultat est supérieur à la limite maximale fixée, qui est dans le cas de ce pneu de l'état de l'art est égale à 264.2788462.

La mise en oeuvre de la méthode selon l'invention consiste à augmenter la largeur axiale **LEp** de chaque nervure épaule, cette largeur **LEp** étant prise égale à 57 mm tout en conservant les valeurs de **Dep** et **PRep** du pneu de référence. On obtient alors **P =** 261.367467, qui satisfait la relation de l'invention à savoir **P(LEp, DEp, PREp)** < 1.105769231 **x F**

Dans une étape intermédiaire, si l'élargissement de la nervure épaule avait été limité par exemple à 52 mm, alors **P** valant 288,254857 ne satisfait pas l'inégalité recherchée. Il faut alors réduire la profondeur des rainures, c'est-à-dire réduire la hauteur de paroi latérale des nervures de bord. Si on choisi de réduire la profondeur de sculpture de 2 mm, **PREp** vaut 14.2 mm. On obtient alors pour **P** une valeur égale à 266.335232, qui ne satisfait toujours pas l'inégalité recherchée. Il faut alors augmenter l'angle de paroi de la nervure épaule jusqu'à une valeur **DEp** égale à 19° pour satisfaire le critère ; dans ce cas, on obtient pour **P** la valeur 263.52595 qui satisfait bien l'inégalité **P(LEp, DEp, PREp)** < 1.105769231 **x F.**

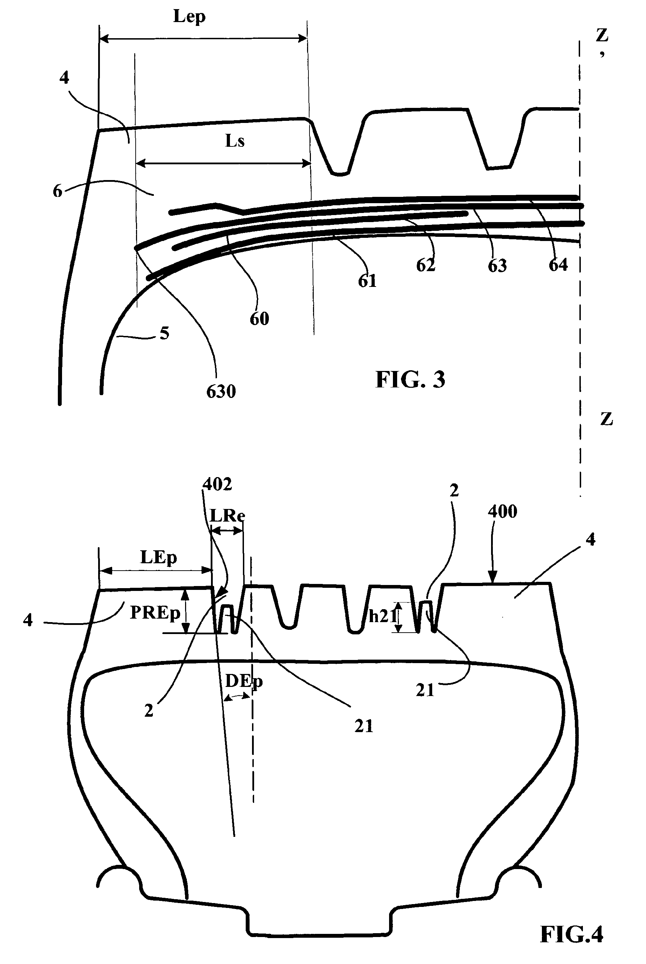

La figure 3 montre une autre variante de pneu selon l'invention, ce pneu comprenant une armature de carcasse 5 surmontée radialement à l'extérieur par une armature de sommet 60 elle même surmontée radialement à l'extérieur par une bande de roulement 1 satisfaisant la relation d'inégalité **P(LEp, DEp, PREp)** < 1.105769231 x F.

En outre, l'armature de sommet 60 comprend plusieurs nappes de renfort 61, 62, 63, 64, au moins une de ces nappes de renfort ayant une plus grande largeur axiale que les autres. Dans le cas présent, c'est la troisième de ces nappes 63 qui est de plus grande largeur axiale.

D'une manière avantageuse, l'extrémité axialement à l'extérieur 630 de la nappe de renfort 63 de l'armature sommet la plus large axialement est à une distance du plan équatorial, ayant la ligne PP' comme trace dans le plan de coupe, qui est supérieure à la distance axiale séparant la rainure axialement le plus à l'extérieure du même plan équatorial, de telle façon que la distance entre l'extrémité de la nappe axialement la plus à l'extérieur et le bord intérieur de la nervure épaule soit au moins égale à 75 % de la largeur totale de la nervure épaule **LEp.** Dans le cas montré avec la figure 3, la largeur Ls d'armature sommet radialement sous la nervure bord est au moins égale à 75% de la largeur **LEp** de la nervure épaule.

La figure 4 montre en coupe une variante d'un pneu selon l'invention, ce pneu comprenant des protubérances de protection de fond de rainures pour éviter que des objets, comme des pierres, rentrent dans les rainures bord et ne puissent s'en échapper pour venir progressivement agresser le fond des rainures et plus particulièrement le fond des rainures bord. On comprend aisément que ces agressions vont augmenter la sensibilité à la cassure des fonds de rainures.

Comme on peut le voir avec la figure 4 montrant une coupe partielle d'un pneu selon l'invention, il est prévu dans les deux rainures bords 2 des protubérances 21, ici discontinues circonférentiellement, ces protubérances 21 ayant une hauteur **h21** égale à 60% de la hauteur **PRep** des nervures de bord 4, et de largeur, mesurée sur sa partie radialement la plus éloignée de l'axe de rotation, égale à la moitié de la largeur **LRe** de la rainure délimitée par la nervure de bord.

La relation d'inégalité **P(LEp, DEp, PREp)** < 1.105769231 x F est ici satisfaite pour un angle d'inclinaison **DEp** de la paroi latérale interne 402 de la nervure bord qui est préférentiellement limité à au plus 6 degrés. Grâce à cette limitation angulaire les protubérances ont une rigidité appropriée. Chaque protubérance peut avoir des parois latérales la délimitant qui sont inclinées d'un angle au plus égal à 6 degrés pour augmenter la rigidité en flexion de ces protubérances.

L'invention n'est pas limitée aux exemples décrits et représentés et diverses modifications peuvent y être apportées sans sortir de son cadre.

**Revendications**

1. Méthode de dimensionnement d'un pneu destiné à être monté sur l'essieu directeur d'un véhicule poids lourd, ce pneu comprenant des bourrelets destinés à être en contact avec une jante de montage du pneu, ces bourrelets étant prolongés par des flancs, ces derniers se raccordant à une région de sommet elle même surmontée par une bande de roulement destinée à venir en contact avec la chaussée en roulage, le pneu ayant une hauteur de flanc **F** nominale, l'armature de sommet comprenant au moins deux nappes de renfort superposées, la bande de roulement (1) ayant à l'état neuf une largeur totale maximale Lo de contact au sol maxi et étant pourvue d'au moins quatre rainures circonférentielles (2) ayant chacune une largeur et s'étendant chacune entre la surface de roulement de la bande de roulement et un fond de rainure, ces rainures(2) délimitant trois nervures intermédiaires (3) et deux nervures de bord (4) limitant axialement ladite bande, chaque nervure de bord (4) ayant deux parois latérales (401, 402), l'une de ces parois latérales, dite paroi latérale interne, ayant une hauteur **PREp** mesurée par rapport au fond de la rainure (2') délimitant ladite nervure de bord, cette paroi latérale interne ayant, vue en coupe dans un plan contenant l'axe de rotation, une inclinaison **DEp,** chaque nervure de bord ayant une largeur **LEp** plus grande que la largeur de chacune des nervures intermédiaires, cette méthode de dimensionnement consistant à déterminer de façon itérative des valeurs des dimensions **LEp, PREp,** et **DEp** qui satisfont la relation suivante :

$$P(LEp, DEp, PREp) < 1.105769231 \times F,$$

où la valeur de **P(LEp,** DEp, **PREp)** est obtenue en effectuant le calcul suivant :

$$P(LEp, DEp, PREp) = -303.528 - 2.00675 \times LEp + 10.2755 \times DEp + 81.0414 \times PREp - 0.052551 \times LEp^2 - 0.0825991 \times LEp \times DEp + 0.225564 \times LEp \times PREp - 0.111262 \times DEp^2 - 0.209215 \times DEp \times PREp - 2.5831 \times PREp^2,$$

les longueurs LEp et **PREp** étant exprimées en millimètres (mm), et l'angle DEp en degrés.

**2.** Méthode de dimensionnement selon la revendication 1 **caractérisée en ce que** pour chaque nervure intermédiaire (3), la différence entre les profondeurs de deux rainures délimitant une même nervure est faible, c'est-à-dire qu'elle est au plus égale à 10% de la plus grande de ces profondeurs.

**3.** Méthode de dimensionnement selon la revendication 1 ou la revendication 2 **caractérisée en ce que** la nervure de bord (4) et la nervure intermédiaire (3) directement adjacente ont des hauteurs différentes, la différence entre ces hauteurs étant au plus égale à 15% de la plus petite des hauteurs.

**4.** Méthode de dimensionnement selon l'une des revendications 1 à 3 **caractérisée en ce que** l'angle **DEp** de la paroi latérale interne de chaque nervure bord est choisi dans un intervalle allant de 10 degrés à 26 degrés (bornes comprises) et l'angle de la paroi latérale en vis-à-vis dans la même rainure est au plus égal à 20 degrés.

**5.** Méthode de dimensionnement selon la revendication 4 **caractérisée en ce que** la largeur de chaque nervure bord **Lep** est choisie de manière à être au moins 1.85 fois supérieure à la largeur de toute autre nervure intermédiaire.

**6.** Méthode de dimensionnement selon l'une des revendications 1 à 5 consistant à choisir un premier triplet de valeurs pour **LEp, PREp,** et **DEp** puis, si la relation **P(LEp, DEp, PREp)** < 1.105769231 x F n'est pas satisfaite, à augmenter dans un premier temps la valeur de la largeur **LEp** de la nervure épaule, ensuite à diminuer la hauteur **PREp** de la paroi latérale interne, et fmalement à augmenter la valeur de l'angle **DEp** de la paroi latérale interne.

**7.** Pneu destiné à être monté sur l'essieu directeur d'un véhicule poids lourd, ce pneu comprenant des bourrelets (7) destinés à être en contact avec une jante de montage (J) du pneu, ces bourrelets étant prolongés par des flancs (10), ces derniers se raccordant à une région de sommet (6) elle même surmontée par une bande de roulement (1) destinée à venir en contact avec la chaussée en roulage, le pneu ayant une hauteur de flanc **F** nominale, une armature de sommet (60) comprenant au moins deux nappes de renfort superposées, la bande de roulement (1) ayant, à l'état neuf, une largeur maximale Lo de contact au sol en conditions usuelles d'usage et, cette bande étant pourvue d'au moins quatre rainures circonférentielles (2) ayant chacune une largeur et s'étendant chacune entre la surface de roulement de la bande de roulement et un fond de rainure (2'), ces rainures circonférentielles (2) délimitant trois nervures intermédiaires (3) et deux nervures de bord (4) limitant axialement ladite bande, chaque nervure de bord (4) ayant deux parois latérales (401, 402), l'une de ces parois latérales, dite paroi latérale interne, ayant une hauteur **PREp** mesurée par rapport au fond de la rainure délimitant ladite nervure de bord, cette paroi latérale interne ayant, vue en coupe dans un plan contenant l'axe de rotation, une inclinaison **DEp,** cet angle étant tel que les points de cette paroi latérale radialement les plus à l'intérieur sont plus proches du plan équatorial du pneu que les points de la même paroi latérale radialement les plus à l'extérieur chaque nervure de bord ayant une largeur **LEp** plus grande que la largeur de chacune des nervures intermédiaires, un plan équatorial perpendiculaire à l'axe de rotation du pneu et passant par les points du pneu radialement les plus éloignés de l'axe de rotation, ce pneu étant **caractérisé en ce que** la largeur de la nervure bord **LEp,** l'angle de la paroi latérale d'une nervure bord **DEp,** et la hauteur **PREp** de la paroi latérale interne de la nervure de bord satisfont la relation suivante :

$$P(LEp, DEp, PREp) < 1.105769231 \times F$$

où la valeur de **P(LEp,** DEp, **PREp)** est obtenue en effectuant le calcul suivant :

$$P(LEp,\ DEp,\ PREp) = -303.528 - 2.00675 \times LEp + 10.2755 \times DEp + 81.0414 \times PREp - 0.052551 \times LEp^2 - 0.0825991 \times LEp \times DEp + 0.225564 \times LEp \times PREp - 0.111262 \times DEp^2 - 0.209215 \times DEp \times PREp - 2.5831 \times PREp^2.$$

8. Pneu selon la revendication 7 **caractérisée en ce que** la largeur Lep de chaque nervure bord (4) est choisie de manière à être au moins 1.85 fois supérieure à la largeur de toute autre nervure intermédiaire (3).

9. Pneu selon la revendication 8 **caractérisé en ce que** l'extrémité axialement à l'extérieur (630) de la nappe (63) de l'armature sommet (60) la plus large axialement est à une distance du plan équatorial qui est supérieure à la distance axiale séparant la rainure axialement la plus à l'extérieur du même plan équatorial, de telle façon que la distance entre l'extrémité de la nappe axialement la plus à l'extérieur et le bord intérieur de la nervure épaule soit au moins égale à 75 % de la largeur totale de la nervure épaule **LEp.**

10. Pneu selon l'une des revendications 7 à 9 **caractérisé en ce que** la largeur de chaque rainure, mesurée sur la surface de roulement à l'état neuf, est au moins égale à 3% de la largeur totale Lo de la bande de roulement.

11. Pneu selon l'une des revendication 7 à 10 **caractérisé en ce que** l'angle d'inclinaison **DEp** de la paroi latérale interne de la nervure bord et l'angle d'inclinaison de la paroi en vis-à-vis de cette paroi latérale interne sont tels que la somme de ces deux angles est supérieure ou égale à 26 degrés.

12. Pneu selon la revendication 11 **caractérisé en ce que** l'angle d'inclinaison DEp de la paroi latérale interne de la nervure bord varie continûment à partir d'une valeur minimale satisfaisant la relation **P(LEp, DEp, PREp)** < 1.105769231x**F**, cette valeur restant supérieure ou égale à 10 degrés.

13. Pneu selon l'une des revendications 7 à 10 **caractérisé en ce que** chaque rainure (2) délimitée par une nervure de bord (4) comprend une pluralité de protubérances (21) de hauteur au moins égale à 50% de la hauteur **PREp** de la nervure bord et de largeur au moins égale à 50% de la largeur LRe de la rainure délimitée par la nervure de bord et **en ce que** l'angle d'inclinaison **DEp** est au plus égal à 6 degrés.

**Patentansprüche**

1. Verfahren für den Entwurf eines Reifens, der dazu bestimmt ist, auf eine Lenkachse eines Lastkraftwagens montiert zu sein, wobei dieser Reifen Wülste aufweist, die dazu bestimmt sind, mit einer Montagefelge des Reifens in Berührung zu sein, wobei diese Wülste durch Flanken verlängert sind, wobei diese Letzteren an einen Scheitelbereich anschließen, über dem wiederum eine Laufdecke liegt, die dazu bestimmt ist, mit der Fahrbahn in Berührung zu kommen, wobei der Reifen eine Flankennennhöhe F aufweist, wobei die Scheitelbewehrung mindestens zwei übereinanderliegende Verstärkungslagen aufweist, wobei die Laufdecke (1) im neuen Zustand eine maximale Gesamtberührungsbreite Lo auf dem Boden aufweist und mit mindestens vier umfänglichen Rillen (2) versehen ist, die jeweils eine Breite haben und sich jeweils zwischen der Laufoberfläche der Laufdecke und einem Rillengrund erstrecken, wobei diese Rillen (2) drei Zwischenrippen (3) und zwei Randrippen (4) abgrenzen, die die Decke axial abgrenzen, wobei jede Randrippe (4) zwei Seitenwände (401, 402) aufweist, wobei eine dieser Seitenwände, innere Seitenwand genannt, eine Höhe PREp hat, die in Bezug auf den Rillengrund (2') gemessen ist, der die Randrippe abgrenzt, wobei diese innere Seitenwand im Schnitt einer Ebene gesehen, die die Rotationsachse enthält, eine Neigung DEp aufweist, wobei jede Randrippe eine Breite LEp hat, die größer ist als die Breite jeder der Zwischenrippen, wobei dieses Entwurfsverfahren darin besteht, iterativ Werte der Maße LEp, PREp und DEp, die die folgende Gleichung erfüllen, zu bestimmen:

$$P(LEp,\ DEp,\ PREp) < 1,105769231 \times F,$$

wobei der Wert von P(LEp, DEp, PREp) durch Ausführen der folgenden Berechnung erzielt wird:

```
P(LEp, DEp, PREp) = -303,528 - 2,00675 x LEp +
10,2755 x DEp + 81,0414 x PREp - 0,052551 x LEp² -
0,0825991 x LEp x DEp + 0,225564 x LEp x PREp -
0,111262 x DEp² - 0,209215 x DEp x PREp - 2,5831 x
PREp²,
```

wobei die Längen LEp und PREp in Millimeter (mm) ausgedrückt sind und der Winkel DEp in Grad ausgedrückt ist.

2. Verfahren für den Entwurf nach Anspruch 1, **dadurch gekennzeichnet, dass** für jede Zwischenrippe (3) der Unterschied zwischen den Tiefen von zwei Rillen, die ein und dieselbe Rippe abgrenzen, gering ist, das heißt, dass er maximal gleich 10 % der größten dieser Tiefen ist.

3. Verfahren für den Entwurf nach Anspruch 1 oder Anspruch 2, **dadurch gekennzeichnet, dass** die Randrippe (4) und die direkt daneben liegende Zwischenrippe (3) unterschiedliche Höhen haben, wobei der Unterschied zwischen diesen Höhen maximal gleich 15 % der kleineren der Höhen ist.

4. Verfahren für den Entwurf nach einem der Ansprüche 1 bis 3, **dadurch gekennzeichnet, dass** der Winkel DEp der inneren Seitenwand jeder Randrippe aus einem Intervall ausgewählt ist, das von 10 Grad bis 26 Grad (inklusive Randwerte) geht, und dass der Winkel der Seitenwand in Gegenüberlage in derselben Rille maximal gleich 20 Grad ist.

5. Verfahren für den Entwurf nach Anspruch 4, **dadurch gekennzeichnet, dass** die Breite jeder Randrippe LEp derart ausgewählt ist, dass sie mindestens 1,85 Mal größer ist als die Breite jeder anderen Zwischenrippe.

6. Verfahren für den Entwurf nach einem der Ansprüche 1 bis 5, das darin besteht, ein erstes Wertetripel für LEp, PREp und DEp auszuwählen und dann, wenn die Beziehung P(LEp, DEp, PREp) < 1,105769231 x F nicht erfüllt wird, zuerst den Wert der Breite LEp der Schulterrippe zu erhöhen, dann den Wert der Höhe PREp der inneren Seitenwand zu verringern, und schließlich den Wert des Winkels DEp der inneren Seitenwand zu erhöhen.

7. Reifen, der dazu bestimmt ist, auf eine Lenkachse eines Kraftfahrzeugs montiert zu werden, wobei dieser Reifen Wülste (7) aufweist, die dazu bestimmt sind, mit einer Montagefelge (J) des Reifens in Berührung zu sein, wobei diese Wülste durch Flanken (10) verlängert sind, wobei diese Letzteren an einen Scheitelbereich (6) anschließen, über dem wiederum eine Laufdecke (1) liegt, die dazu bestimmt ist, mit der Fahrbahn in Berührung zu kommen, wobei der Reifen eine Flankennennhöhe F aufweist, eine Scheitelbewehrung (60), die mindestens zwei übereinanderliegende Verstärkungslagen aufweist, wobei die Laufdecke (1) im neuen Zustand eine maximale Berührungsbreite Lo auf dem Boden unter gewöhnlichen Nutzungsbedingungen aufweist, und wobei dieses Band mit mindestens vier umfänglichen Rillen (2) versehen ist, die jeweils eine Breite haben und sich jeweils zwischen der Fahroberfläche der Laufdecke und einem Rillengrund (2') erstrecken, wobei diese umfänglichen Rillen (2) drei Zwischenrippen (3) und zwei Randrippen (4) abgrenzen, die die Decke axial abgrenzen, wobei jede Randrippe (4) zwei Seitenwände (401, 402) aufweist, wobei eine dieser Seitenwände, innere Seitenwand genannt, eine Höhe PREp in Bezug auf den Grund der Rille gemessen, der die Randrippe abgrenzt, aufweist, wobei diese innere Seitenwand im Schnitt einer Ebene gesehen, die die Rotationsachse enthält, eine Neigung DEp aufweist, wobei dieser Winkel derart ist, dass die Punkte dieser Seitenwand, die radial am weitesten innen liegen, der Mittelebene des Reifens näher liegen als die Punkte derselben Seitenwand, die radial am weitesten außen liegen, wobei jede Randrippe eine Breite LEp aufweist, die größer ist als die Breite jeder der Zwischenrippen, eine Mittelebene, die senkrecht zu der Rotationsachse des Reifens ist und durch die Punkte des Reifens verläuft, die radial am weitesten von der Rotationsachse entfernt sind, wobei dieser Reifen **dadurch gekennzeichnet ist, dass** die Breite der Randrippe LEp, der Winkel der Seitenwand einer Randrippe DEp sowie die Höhe PREp der inneren Seitenwand der Randrippe die folgende Gleichung erfüllen:

$$P(LEp, DEp, PREp) < 1,105769231 \times F$$

wobei der Wert von P(LEp, DEp, PREp) durch Ausführen der folgenden Berechnung erzielt wird:

$$P(LEp, DEp, PREp) = -303,528 - 2,00675 \times LEp + 10,2755 \times DEp + 81,0414 \times PREp - 0,052551 \times LEp^2 - 0,0825991 \times LEp \times DEp + 0,225564 \times LEp \times PREp - 0,111262 \times DEp^2 - 0,209215 \times DEp \times PREp - 2,5831 \times PREp^2.$$

**8.** Reifen nach Anspruch 7, **dadurch gekennzeichnet, dass** die Breite LEp jeder Randrippe (4) derart ausgewählt ist, dass sie mindestens 1,85 Mal größer ist als die Breite jeder anderen Zwischenrippe (3).

**9.** Reifen nach Anspruch 8, **dadurch gekennzeichnet, dass** das axiale Ende (630) außerhalb der Lage (63) der Scheitelbewehrung (60), das axial am breitesten ist, in einer Entfernung von der Mittelebene liegt, die größer ist als die axiale Entfernung, die die axiale Rippe, die am weitesten außerhalb derselben Mittelebene liegt, trennt, derart, dass die Entfernung zwischen dem Ende der axial am weitesten außen liegenden Lage und dem inneren Rand der Schulterrippe mindestens gleich 75 % der Gesamtbreite der Schulterrippe LEp ist.

**10.** Reifen nach einem der Ansprüche 7 bis 9, **dadurch gekennzeichnet, dass** die Breite jeder Rille, auf der Laufoberfläche im neuen Zustand gemessen, mindestens gleich 3 % der Gesamtbreite Lo der Laufdecke ist.

**11.** Reifen nach einem der Ansprüche 7 bis 10, **dadurch gekennzeichnet, dass** der Neigungswinkel DEp der inneren Seitenwand der Randrippe und der Neigungswinkel der Wand gegenüber dieser inneren Seitenwand derart sind, dass die Summe dieser zwei Winkel größer oder gleich 26 Grad ist.

**12.** Reifen nach Anspruch 11, **dadurch gekennzeichnet, dass** der Neigungswinkel DEp der inneren Seitenwand der Randrippe laufend ausgehend von einem Mindestwert, der die Beziehung P(LEp, DEp, PREp) < 1,105769231 x F erfüllt, variiert, wobei dieser Wert größer oder gleich 10 Grad bleibt.

**13.** Reifen nach einem der Ansprüche 7 bis 10, **dadurch gekennzeichnet, dass** jede Rille (2), die von einer Randrippe (4) abgegrenzt ist, eine Mehrzahl von Vorsprüngen (21) mit einer Höhe aufweist, die mindestens gleich 50 % der Höhe PREp der Randrippe ist, und einer Breite mindestens gleich 50 % der Breite LRe der Rippe ist, die von der Randrippe abgegrenzt ist, und dass der Neigungswinkel DEp maximal gleich 6 Grad ist.

**Claims**

**1.** Method of designing a tyre intended to be fitted to the steered axle of a heavy goods vehicle, this tyre comprising beads intended to be in contact with a rim on which the tyre is mounted, these beads being extended by sidewalls, the latter meeting in a crown region itself surmounted by a tread intended to come into contact with the road surface during running, the tyre having a nominal sidewall height **F,** the crown reinforcement comprising at least two superposed reinforcer plies, the tread (1) in the new state having a maximum total width **Lo** for maximum contact with the ground and being provided with at least four circumferential grooves (2) each having a width and each extending between the tread surface of the tread and a groove bottom, these grooves (2) delimiting three intermediate ribs (3) and two edge ribs (4) axially bounding the said tread, each edge rib (4) having two lateral walls (401, 402), one of these lateral walls, known as the internal lateral wall, having a height **PREp** measured with respect to the bottom of the groove (2') delimiting the said edge rib, this internal lateral wall having, when viewed in section on a plane containing the axis of rotation, an inclination **DEp,** each edge rib having a width **LEp** greater than the width of each of the intermediate ribs, this design method involving iteratively determining values for the dimensions **LEp, PREp** and **DEp** that satisfy the following relationship:

$$\mathbf{P(LEp,\ DEp,\ PREp)}\ <\ 1.105769231\ \mathrm{x}\ \mathbf{F},$$

where the value of **P(LEp, DEp, PREp)** is obtained by making the following calculation:

$$\mathbf{P(LEp,\ DEp,\ PREp)}\ =\ -303.528\ -\ 2.00675\ \mathrm{x}\ \mathbf{LEp}\ +$$
$$10.2755\ \mathrm{x}\ \mathbf{DEp}\ +\ 81.0414\ \mathrm{x}\ \mathbf{PREp}\ -\ 0.052551\ \mathrm{x}\ \mathbf{LEp}^2\ -$$
$$0.0825991\ \mathrm{x}\ \mathbf{LEp}\ \mathrm{x}\ \mathbf{DEp}\ +\ 0.225564\ \mathrm{x}\ \mathbf{LEp}\ \mathrm{x}\ \mathbf{PREp}\ -$$
$$0.111262\ \mathrm{x}\ \mathbf{DEp}^2\ -\ 0.209215\ \mathrm{x}\ \mathbf{DEp}\ \mathrm{x}\ \mathbf{PREp}\ -\ 2.5831\ \mathrm{x}$$
$$\mathbf{PREp}^2,$$

the lengths **LEp** and **PREp** being expressed in millimetres (mm), and the angle DEp in degrees.

2. Design method according to Claim 1, **characterized in that**, for each intermediate rib (3), the difference between the depths of two grooves delimiting one and the same rib is small, i.e. it is at most equal to 10% of the larger of these depths.

3. Design method according to Claim 1 or Claim 2, **characterized in that** the edge rib (4) and the immediately adjacent intermediate rib (3) have different heights, the difference between these heights being at most equal to 15% of the shorter of the heights.

4. Design method according to one of Claims 1 to 3, **characterized in that** the angle **DEp** of the internal lateral wall of each edge rib is chosen in an interval ranging from 10 degrees to 26 degrees (inclusive of limits) and the angle of the lateral wall opposite in the same groove is at most equal to 20 degrees.

5. Design method according to Claim 4, **characterized in that** the width of each edge rib **Lep** is chosen so as to be at least 1.85 times greater than the width of any other intermediate rib.

6. Design method according to one of Claims 1 to 5 involving choosing a first triplet of values for **LEp, PREp** and **DEp** and then, if the relationship **P(LEp, DEp, PREp)** < 1.105769231 x **F** is not satisfied, first of all increasing the value of the width **LEp** of the shoulder rib, then decreasing the height **PREp** of the internal lateral wall and finally increasing the value of the angle **DEp** of the internal lateral wall.

7. Tyre intended to be fitted to the steered axle of a heavy goods vehicle, this tyre comprising beads (7) intended to be in contact with a rim (J) on which the tyre is mounted, these beads being extended by sidewalls (10), the latter meeting in a crown region (6) itself surmounted by a tread (1) intended to come into contact with the road surface during running, the tyre having a nominal sidewall height **F,** a crown reinforcement (60) comprising at least two superposed reinforcer plies, the tread (1) in the new state having a maximum width **Lo** for contact with the ground under conventional conditions of use and, this tread being provided with at least four circumferential grooves (2) each having a width and each extending between the tread surface of the tread and a groove bottom (2'), these circumferential grooves (2) delimiting three intermediate ribs (3) and two edge ribs (4) axially bounding the said tread, each edge rib (4) having two lateral walls (401, 402), one of these lateral walls, known as the internal lateral wall, having a height **PREp** measured with respect to the bottom of the groove delimiting the said edge rib, this internal lateral wall having, when viewed in section on a plane containing the axis of rotation, an inclination **DEp,** this angle being such that the points of this lateral wall that are radially furthest inwards are closer to the equatorial plane of the tyre than the points of the same lateral wall that are radially outermost, each edge rib having a width **LEp** greater than the width of each of the intermediate ribs, an equatorial plane perpendicular to the axis of rotation of the tyre and passing through the points of the tyre that are radially furthest away from the axis of rotation, this tyre being **characterized in that** the width of the edge rib **LEp,** the angle of the lateral wall of an edge rib **DEp,** and the height **PREp** of the internal lateral wall of the edge rib satisfy the following relationship:

$$P\texttt{(LEp, DEp, PREp)} < 1.105769231 \texttt{ x } F,$$

where the value of **P(LEp, DEp, PREp)** is obtained by making the following calculation:

$$\begin{aligned}
P\texttt{(LEp, DEp, PREp)} &= -303.528 - 2.00675 \texttt{ x LEp} + \\
&10.2755 \texttt{ x DEp} + 81.0414 \texttt{ x PREp} - 0.052551 \texttt{ x LEp}^2 - \\
&0.0825991 \texttt{ x LEp x DEp} + 0.225564 \texttt{ x LEp x PREp} - \\
&0.111262 \texttt{ x DEp}^2 - 0.209215 \texttt{ x DEp x PREp} - 2.5831 \texttt{ x} \\
&PREp^2.
\end{aligned}$$

8. Tyre according to Claim 7, **characterized in that** the width **Lep** of each edge rib (4) is chosen so as to be at least 1.85 times greater than the width of any other intermediate rib (3).

9. Tyre according to Claim 8, **characterized in that** the axially outer end (630) of the axially widest ply (63) of the crown reinforcement (60) is at a distance from the equatorial plane that is greater than the axial distance separating the axially outermost groove from that same equatorial plane such that the distance between the axially outermost ply end and the inner edge of the shoulder rib is at least equal to 75% of the total width of the shoulder rib **LEp.**

10. Tyre according to one of Claims 7 to 9, **characterized in that** the width of each groove, measured on the tread surface in the new state, is at least equal to 3% of the total width **Lo** of the tread.

11. Tyre according to one of Claims 7 to 10, **characterized in that** the angle of inclination **DEp** of the internal lateral wall of the edge rib and the angle of inclination of the wall opposite this internal lateral wall are such that the sum of these two angles is greater than or equal to 26 degrees.

12. Tyre according to Claim 11, **characterized in that** the angle of inclination DEp of the internal lateral wall of the edge rib varies continuously from a minimum value that satisfies the relationship **P(LEp, DEp, PREp)** < 1.105769231x**F**, this value remaining greater than or equal to 10 degrees.

13. Tyre according to one of Claims 7 to 10, **characterized in that** each groove (2) delimited by an edge rib (4) comprises a plurality of protrusions (21) of a height at least equal to 50% of the height **PREp** of the edge rib and of a width at least equal to 50% of the width LRe of the groove delimited by the edge rib and **in that** the angle of inclination **DEp** is at most equal to 6 degrees.

**FIG.1**

**FIG.2**

**FIG. 3**

**FIG.4**

**EP 2 509 804 B1**

RÉFÉRENCES CITÉES DANS LA DESCRIPTION

**Documents brevets cités dans la description**

- US 20070151643 A